# EUROPEAN PATENT SPECIFICATION

(11) **EP 2 378 605 B1**
(45) Date of publication and mention of the grant of the patent: **04.12.2013**
(21) Application number: 11160197.7
(22) Date of filing: 29.03.2011
(51) Int. Cl.: H01M 10/48, G01R 31/36

(54) **System and method for displaying battery string data in polar coordinate graphical form**
System und Verfahren zur Anzeige von Batteriereihendaten in graphischer Polarkoordinatenform
Système et procédé d'affichage de données de chaîne de batterie sur une forme graphique à coordonnée polaire

(30) Priority: 29.03.2010 US 318550 P
(43) Date of publication of application: 19.10.2011
(73) Proprietor: Liebert Corporation, Columbus, OH 43085 (US)
(72) Inventor: Weymans, David, Plantation, FL 33324 (US); Deveau, Eddie, Pompano Beach, FL 33062 (US); Drozd, Peter, Raleigh, NC 27612 (US)
(74) Representative: Bryn-Jacobsen, Caelia

(56) References cited:
- WO-A1-2005/019849
- WO-A2-03/047064
- DE-A1-102005 026 583
- US-A1- 2006 220 897
- US-B1- 6 532 425

## Description

### FIELD

The present disclosure relates to a battery monitoring system and the graphical display of battery string cell data monitored by the battery monitoring system.

### BACKGROUND

This section provides background information related to the present disclosure which is not necessarily prior art.

Uninterruptible power supply systems, such as those used for data centers, often utilize batteries as the source of back-up power. Each battery typically has multiple cells or multicell modules connected in series to provide the requisite voltage, commonly referred to as a battery string. The term "cell" will be used herein to refer to both individual cells and multicell modules of a battery string unless the context dictates otherwise. A battery may have multiple battery strings.

Since a battery has a finite life, it will eventually fail. Consequently, battery monitors are often used to monitor the batteries in UPS systems. By detecting battery problems at an early stage before they can cause abrupt system failure, system reliability is improved.

One type of battery monitor used to monitor the batteries in UPS systems monitors the state of health of each cell in a battery string and depending on the configuration of the monitor, may monitor one or several batteries with each battery having a battery string of cells connected in series. Such a battery may have a plurality of battery strings connected in parallel. In battery monitors available from Alber of Pompano Beach, Florida, such as the BDS series of battery monitors, the internal resistance of each cell module in the battery string or battery strings of each battery is measured as the internal resistance of a cell is a reliable indicator of that cell's state of health. The battery monitors also monitor other parameters, such as cell voltage, overall voltage, ambient temperature of the battery, inter tier resistance, discharge current, discharge events, float current, and the like. The battery monitors will alert a user if the monitored data shows a problem with the batteries being monitored. The battery monitors typically interface to a computer, local or remote, that is programmed to display the monitored data.

The battery monitors may for example utilize the teachings of U.S. 4,707,795 for "Battery Testing and Monitoring System" issued November 17, 1987 and/or U.S. Pub. No. 2009/0224771 for "System and method for Measuring Battery Internal Resistance," published September 10, 2009.

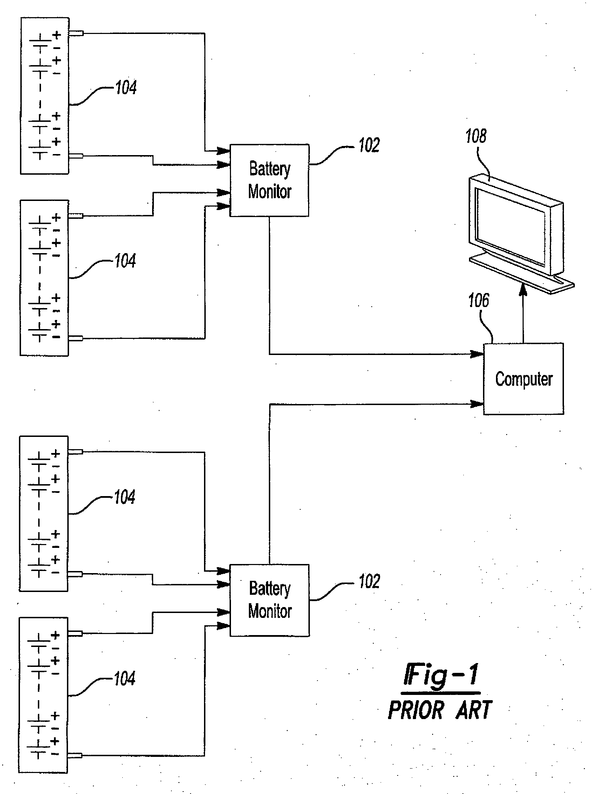

Fig. 1 shows a prior art battery monitoring system 100 having a plurality of battery monitors 102 (such as a BDS series battery monitor) that are configured to monitor a plurality of battery strings 104. Battery monitors 102 are coupled to a computer 106 to which they transmit battery string cell data obtained by monitoring battery strings 104 including data obtained by monitoring parameters of each cell in battery strings 104. The battery string cell data is typically collected by the battery monitor in periodic scans, such as every one to four seconds. Computer 106 includes programming that formats the battery string cell data for display in graphical form on a display 108 coupled to computer 106.

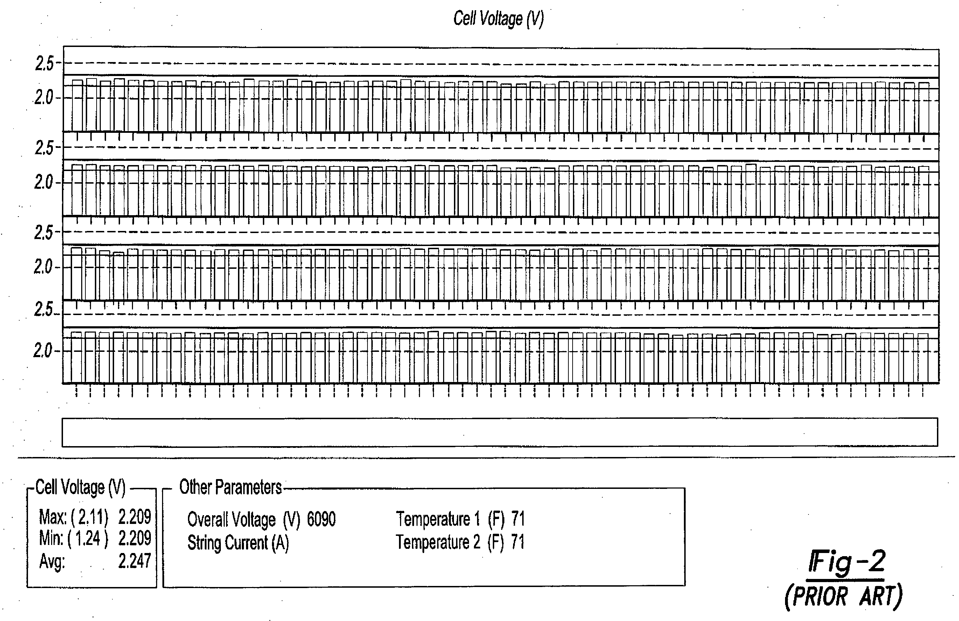

The graphical from in which the data for the individual cells of battery strings 104 has been displayed on display 108 has been a bar chart having a series of bars with each bar representative of the datum for a monitored parameter for an individual cell in the battery string. Such a display for a 240 cell battery string is shown in Fig. 2. The battery string cell data shown in Fig. 2 is the cell voltage. Other battery string cell data can be shown in similar form by selecting the type of data to be displayed such as the internal resistances of the cells of the battery string. Displaying the battery string cell data with this type of view limits the display to a single battery string as this type of display takes up most if not all the screen of the display.
US 6532425 relates to a system for monitoring performance of one or more batteries in a battery plant facility. A set of sensors for each battery are used to measure a plurality of battery operation parameters comprising the battery current, a battery voltage, an internal battery temperature of each set battery. WO 03/047064 relates to a remote battery monitoring system and sensors in which a plurality of telesensors are connected to batteries in a battery string. US 2006/220897 relates to a notebook with power indication where the notebook includes a main unit, a battery, a power indicator and a sensor. DE 10 2005 026583 relates to a battery system. WO 2005/019849 relates to a method and device for displaying the remaining useful life of a battery.

### SUMMARY

The present invention is set out in the independent claims, with some optional features set out in the claims dependent thereto.

This section provides a general summary of the disclosure, and is not a comprehensive disclosure of its full scope or all of its features.

In accordance with an aspect of the present disclosure, battery string cell data obtained by a battery monitor monitoring the battery string is transmitted to a computer by the battery monitor. The computer has a display coupled to it. The computer displays the battery string cell data for each battery string in graphical form in a polar coordinate graphical image with data for a plurality of battery strings being displayed simultaneously, each in its own polar coordinate graphical image.

In an aspect, the computer receives battery string cell data for a plurality of battery strings and displays simultaneously on the display the battery string cell data for each battery string with the battery string cell data for each battery string displayed on the display in a separate polar coordinate graphical image.
In an aspect, the battery string cell data for each battery string includes a cell datum for each cell in the battery string, wherein the polar coordinate graphical image includes a wheel and spoke image having a spoke extending from a hub for each cell datum wherein each spoke is scaled so that its length corresponds to a value of the cell datum.

Further areas of applicability will become apparent from the description provided herein. The description and specific examples in this summary are intended for purposes of illustration only and are not intended to limit the scope of the present disclosure.

### DRAWINGS

The drawings described herein are for illustrative purposes only of selected embodiments and not all possible implementations, and are not intended to limit the scope of the present disclosure.

Fig. 1 is a simplified schematic of a prior art battery monitoring system:

Fig. 2 is a prior art graphical display of battery string cell data;

Fig. 3 is a simplified schematic of a battery monitoring system in accordance with an aspect of the present disclosure;

Fig. 4 is a polar coordinate graphical image of battery string cell data in accordance with an aspect of the present disclosure;

Fig. 5 is a flow chart of a program for generating the polar coordinate graphical image of Fig. 4; and

Fig. 6 is a flow chart showing in more detail a block of the flow chart of Fig. 5.

Corresponding reference numerals indicate corresponding parts throughout the several views of the drawings.

### DETAILED DESCRIPTION

Example embodiments will now be described more fully with reference to the accompanying drawings.

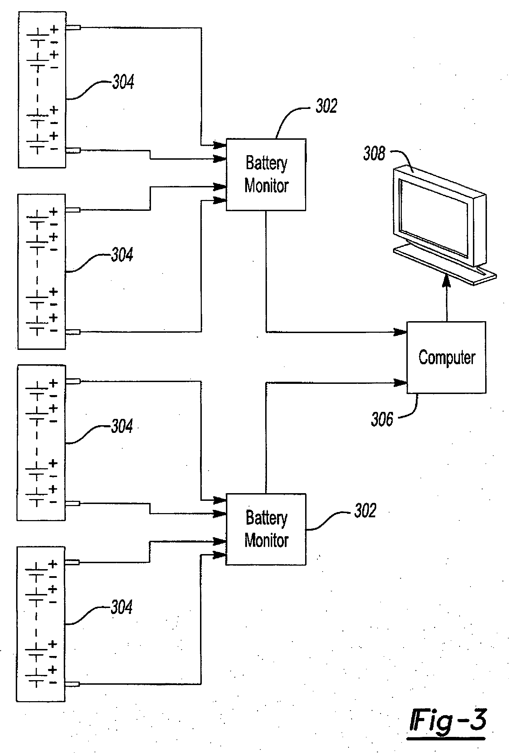

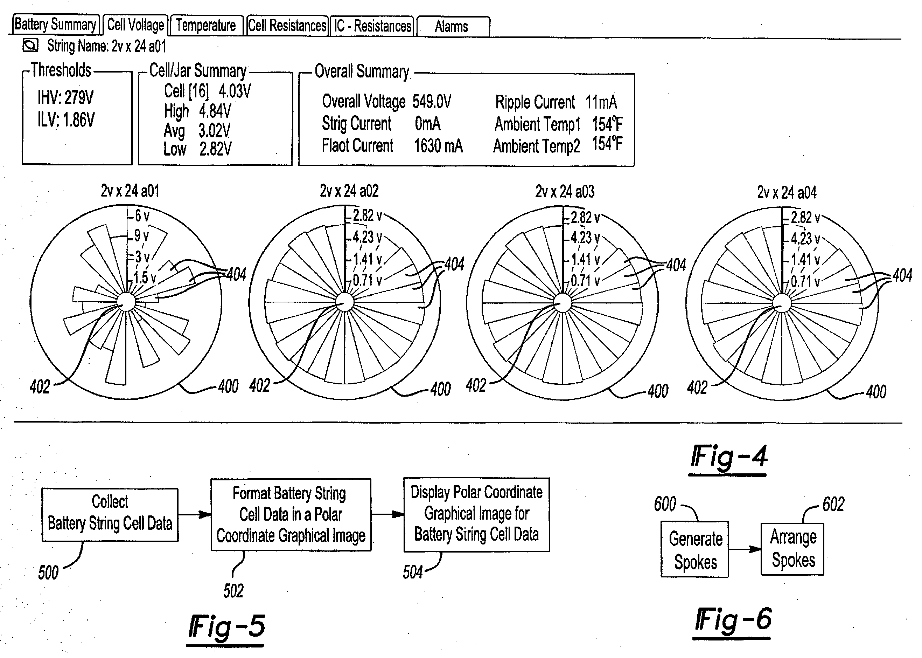

Fig. 3 shows a system 300 in accordance with an aspect of the present disclosure in which battery string cell data obtained by monitoring the cells of a battery string or battery strings with a battery monitor (or monitors) 302 is displayed in polar coordinate graphical form permitting simultaneous displays of data for multiple battery strings. Appropriate sensors (not shown) are coupled to battery strings 304 and to battery monitors 302 which measure or otherwise sense parameters of the battery strings 304 including parameters for the individual cells of the battery strings 304 as discussed above. Battery monitors 302 are coupled to computer 306 and transmit the monitored data to computer 306 including the data for the individual cells of the battery strings 304. Computer 306 is programmed with appropriate software to display the monitored data obtained from battery monitors 302 in graphical form including displaying on display 308 the battery string cell data for a battery string in a polar coordinate graphical image 400 (Fig. 4). This allows battery string cell data for a plurality of battery strings to be displayed simultaneously on display 308. In an aspect, a plurality of coordinate graphical images 400 for a plurality of battery strings are displayed simultaneously on display 308. This battery string cell data illustratively includes a cell datum for each cell in the battery string.

By providing for the display of battery string cell data on display 308 for multiple battery strings at the same time, a user can monitor more than one battery string at a time on display 308. This is advantageous when a user is monitoring a battery having a plurality of battery strings. As discussed in the Background section, battery monitors have historically displayed battery string cell data in the traditional bar chart or text tabular data for a single battery string. However, in viewing battery cell discharges in real-time, it is important to identify failing battery cell voltages or rising battery cell temperatures as early as possible so action can be taken as needed. For example, if the test is being manually controlled, the user can choose to terminate the test early. The foregoing allows a user to stay on one screen displayed on screen 308 while performing or monitoring battery cell discharges and see the data for the battery strings in the battery when the battery has more than one battery string. In the prior art battery monitors, the user had to constantly change the screens being displayed on display 308 to see the data for the different battery strings and remember where potential problems could be developing.

The above described display of battery string cell data by a polar coordinate graphical image 400 advantageously provides the ability to simultaneously display the monitored data for more than one battery string on a screen displayed on display 308.

In an aspect of the present disclosure, the polar coordinate graphical image 400 in which the battery string cell data of a battery string 304 is displayed on display 308 is in the form of a pie chart or "wheel and spoke" form as shown in Fig. 4. Each cell datum is shown by a spoke 404 extending radially outwardly from a hub 402. The spoke for each cell datum is scaled so that the length of the spoke 404 corresponds to the value of the cell datum. In an aspect, the spokes 404 are arranged in sequence clockwise around hub 402. For example, if the battery string 304 has forty cells as shown in the illustrative embodiment of Fig. 4, the polar coordinate graphical image 400 will have forty spokes with the spokes 404 running sequentially from cell 1 to cell 40 clockwise around hub 402. In the embodiment of Fig. 4, the spokes 404 are shaped as triangular "pie segments." It should be understood that spokes 404 can have other shapes, such as lines.

As shown in Fig. 4, cell voltages for four battery strings 304 are displayed simultaneously, with a polar coordinate graphical image 400 for the cell voltages of each battery string 304. Other types of cell data, such as the internal resistances of the cells or the temperatures of the cells, can be similarly displayed in a polar coordinate graphical display 400.

Fig. 5 is a flow chart of an illustrative software program by which computer 306 is programmed to display the battery string cell data in polar coordinate graphical form and generate polar coordinate graphical image 400. With reference to the flow chart of Fig. 5, the monitored data for the battery strings 304 is collected by computer 306, such as by a battery monitor (or monitors) 302 transmitting the battery string cell data to computer 306. In this regard, as discussed, the battery strings 304 are monitored with battery monitor(s) 302 that measures or otherwise senses parameters of the battery strings 304 including parameters of the individual cells of the battery strings 304, such as cell voltage and internal cell resistance.

At 502, the battery string cell data for cells of each battery string 304 are formatted into a respective polar coordinate graphical images 400. At 504, computer 306 displays the polar coordinate graphical image or images 400 for one or more battery strings 304. As shown in Fig. 4, battery string cell data for a plurality of battery strings 304 can be displayed simultaneously with the battery string cell data for each battery string 304 being displayed in a respective polar coordinate graphical image 400.

Fig. 6 shows in more detail block 502 of Fig. 5. At 600, computer 306 generates a spoke for each cell datum of the type of parameter to be displayed, cell voltage for example. If for example, the battery string 304 has forty cells, there will be forty spokes. The spoke is scaled based on the value of the cell datum. At 602, the spokes are arranged in polar coordinate graphical image 400 so that they extend radially outwardly from a hub.

With reference to Fig. 4, in an aspect clicking on hub 402 of one of the polar graphical images 400 will change to the display of the battery string cell data to the typical prior art bar chart shown in Fig. 2.

In an aspect, clicking on a spoke 404 of one of the polar graphical images 400 will result in a trend of the battery string cell data for the selected battery cell (that the selected spoke 404 represents) being displayed. For example, the battery string cell data for the selected battery cell for a period of time, such as a week or a month, may be displayed.

In an aspect, the polar graphical images 400 may include annular rings indicating high and/or low alarm thresholds. When a value of the battery string cell datum for a cell goes above or below the alarm threshold, the color of the spoke for that battery cell changes color.

The foregoing description of the embodiments has been provided for purposes of illustration and description. It is not intended to be exhaustive or to limit the invention. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the invention, and all such modifications are intended to be included within the scope of the invention as defined by the following claims.

## Claims

1. A system (300) for displaying battery string cell data, comprising:
a battery monitor (302);
a display (308)
a computer (306) that receives the battery string cell data from the battery monitor (302) that collects the battery string cell data from a battery string (304); in which the battery string includes a cell datum for each cell in the battery string;
the computer arranged to display the string cell data in a graphical form in a polar coordinate graphical image of a wheel and spoke graphical image (400) having a spoke extending from a hub for each cell datum wherein each spoke is scaled so that its length corresponds to a value of the cell datum.

2. The system of claim 1 wherein the computer receives battery string cell data for a plurality of battery strings and displays simultaneously on the display the battery string cell data for each battery string with the battery string cell data for each battery string displayed on the display in a separate polar coordinate graphical image.

3. The system of claim 2 wherein the battery string cell data for each battery string includes a cell datum for each cell in the battery string, wherein the polar coordinate graphical image includes a wheel and spoke image having a spoke extending from a hub for each cell datum wherein each spoke is scaled so that its length corresponds to a value of the cell datum.

4. A battery monitor system, comprising:
a battery string including a cell datum for each cell in the battery string;
a display (308);
a battery monitor that monitors and collects battery string cell data from the battery string; a computer that receives the battery string (304) cell data from the battery monitor (302); the computer (306) arranged to display the battery string cell data on the display in a graphical form in a polar coordinate graphical image of a wheel and spoke graphical image (400) havinga spoke extending from a hub for each cell datum wherein each spoke is scaled so that its length corresponds to a value of the cell datum.

5. The system of claim 4 including a plurality of battery monitors that monitor and collect battery string cell data from a plurality of battery strings, the computer receiving the battery string cell data for the plurality of battery cells from the plurality of battery monitors and displaying simultaneously on the display the battery string cell data for each battery string with the battery string cell data for each battery string displayed on the display in a separate polar coordinate graphical image.

6. The system of claim 5, wherein the battery string cell data for each battery string includes a cell datum for each cell in the battery string, wherein the polar coordinate graphical image includes a wheel and spoke image having a spoke extending from a hub for each cell datum wherein each spoke is scaled so that its length corresponds to a value of the cell datum.

7. A method of displaying battery string cell data, comprising:
receiving with a computer (306) the battery string cell data from a battery monitor (302) that collects the battery string cell data from the battery string (304) in which the battery string includes a cell datum for each cell in the battery string; and
formatting with the computer the battery string cell data into a polar coordinate graphical image of a wheel and scope graphical image (400) having a spoke extending from a hub for each cell datum wherein each spoke is scaled so that its length corresponds to a value of the cell datum and displaying with the computer the wheel and spoke graphical image on the display.

8. The method of claim 7,including receiving with the computer battery string cell data for a plurality of battery strings and with the computer displaying simultaneously on the display the battery string cell data for each battery string with the battery string cell data for each battery string displayed on the display in a separate wheel and spoke graphical image wherein the wheel and spoke graphical image for each battery string has a spoke extending from a hub for each cell datum of the battery string that is scaled so that its length corresponds to the value of the cell datum.

9. The method of claim 8, wherein each spoke is any of a line or a pie shaped segment.

## Patentansprüche

1. System (300) zum Anzeigen von Batteriestrang-Zellendaten, aufweisend:
eine Batterieüberwachungseinrichtung (302);
eine Anzeigeeinrichtung (308);
einen Computer (306), der die Batteriestrang-Zellendaten aus der Batterieüberwachungseinrichtung (302) empfängt, die die Batteriestrang-Zellendaten aus einem Batteriestrang (304) sammelt, in welchen der Batteriestrang einen Zellenbezugswert für jede Zelle in dem Batteriestrang enthält;
wobei der Computer dafür eingerichtet ist, die Strangzellendaten in einer graphischen Form in einem graphischen Polarkoordinatenbild eines Rades und eines graphischen Bildes (400) einer Speiche mit einer sich von einer Nabe aus für jeden Zellenbezugswert erstreckenden Speiche darzustellen, wobei jede Speiche so skaliert ist, dass ihre Länge einem Wert des Zellenbezugswertes entspricht.

2. System nach Anspruch 1, wobei der Computer Batteriestrang-Zellendaten für mehrere Batteriestränge empfängt und gleichzeitig auf der Anzeigeeinrichtung die Batteriestrang-Zellendaten für jeden Batteriestrang darstellt, wobei die Batteriestrang-Zellendaten für jeden Batteriestrang auf der Anzeigeeinrichtung in einem getrennten graphischen Polarkoordinatenbild dargestellt werden.

3. System nach Anspruch 2, wobei die Batteriestrang-Zellendaten für jeden Batteriestrang einen Zellenbezugswert für jede Zelle in dem Batteriestrang enthalten, wobei das graphische Polarkoordinatenbild ein Rad- und Speichenbild mit einer sich von einer Nabe aus für jeden Zellenbezugswert erstreckenden Speiche enthält, wobei jede Speiche so skaliert ist, dass ihre Länge einem Wert des Zellenbezugswertes entspricht.

4. Batterieüberwachungssystem, aufweisend:
einen Batteriestrang mit einem Zellenbezugswert für jede Zelle in dem Batteriestrang;
eine Anzeigeeinrichtung (308);
eine Batterieüberwachungseinrichtung, die Batteriestrang-Zellendaten aus dem Batteriestrang überwacht und sammelt; einen Computer, der die Zellendaten des Batteriestrangs (304) aus der Batterieüberwachungseinrichtung (302) empfängt; wobei der Computer (306) dafür eingerichtet ist, die Batteriestrang-Zellendaten auf der Anzeigeeinrichtung in einem graphischen Polarkoordinatenbild eines Rades und eines graphischen Speichenbildes (400) mit einer sich von einer Nabe aus für jeden Zellenbezugswert erstreckenden Speiche dazustellen, wobei jede Speiche so skaliert ist, dass ihre Länge einem Wert des Zellenbezugswertes entspricht.

5. System nach Anspruch 4, das mehrere Batterieüberwachungseinrichtungen enthält, die Batteriestrang-Zellendaten von mehreren Batteriesträngen überwachen und sammeln, wobei der Computer die Batteriestrang-Zellendaten für die mehreren Batteriestränge von den mehreren Batterieüberwachungseinrichtungen empfängt und gleichzeitig auf der Anzeigeeinrichtung die Batteriestrang-Zellendaten für jeden Batteriestrang darstellt, wobei die Batteriestrang-Zellendaten für jeden Batteriestrang auf der Anzeigeeinrichtung in einem getrennten graphischen Polarkoordinatenbild dargestellt werden.

6. System nach Anspruch 5, wobei die Batteriestrang-Zellendaten für jeden Batteriestrang einen Zellenbezugswert für jede Zelle in dem Batteriestrang enthalten, wobei das graphische Polarkoordinatenbild ein Rad- und Speichenbild mit einer sich von einer Nabe aus für jeden Zellenbezugswert erstreckenden Speiche enthält, wobei jede Speiche so skaliert ist, dass ihre Länge einem Wert des Zellenbezugswertes entspricht.

7. Verfahren zum Darstellen von Batteriestrang-Zellendaten, mit den Schritten:
Empfangen, mittels eines Computers (306), der Batteriestrang-Zellendaten aus einer Batterieüberwachungseinrichtung (302), die die Batteriestrang-Zellendaten von dem Batteriestrang (304) sammelt, in welchen der Batteriestrang einen Zellenbezugswert für jede Zelle in dem Batteriestrang enthält; und
Formatieren, mittels eines Computers, der Batteriestrang-Zellendaten in ein graphisches Polarkoordinatenbild eines Rades und eines graphischen Bildes (400) einer Speiche mit einer sich von einer Nabe aus für jeden Zellenbezugswert erstreckenden Speiche, wobei jede Speiche so skaliert ist, dass ihre Länge einem Wert des Zellenbezugswertes entspricht und Darstellen des graphischen Rad- uns Speichenbildes mittels des Computers.

8. Verfahren nach Anspruch 7, mit dem Schritt des Empfangs von Batteriestrang-Zellendaten für mehrere Batteriestränge mittels des Computers und der gleichzeitigen Darstellung der Batteriestrang-Zellendaten mittels des Computers auf der Anzeigeeinrichtung der Batteriestrang-Zellendaten für jeden Batteriestrang, wobei die Batteriestrang-Zellendaten für jeden Batteriestrang auf der Anzeigeeinrichtung in einem getrennten graphischen Rad- und Speichenbild dargestellt werden, wobei das graphische Rad- und Speichenbild für jeden Batteriestrang eine sich von einer Nabe aus für jeden Zellenbezugswert des Batteriestrangs erstreckende Speiche hat, die so skaliert ist, dass ihre Länge einem Wert des Zellenbezugswertes entspricht.

9. Verfahren nach Anspruch 8, wobei jede Speiche eine von einem linien- oder einem tortenstückförmigen Segment ist.

## Revendications

1. Système (300) pour afficher des données de cellules de chaînes de batteries, comprenant :
un dispositif de surveillance de batteries (302) ;
un écran d'affichage (308) ;
un ordinateur (306) qui reçoit les données de cellules de chaînes de batteries à partir du dispositif de surveillance de batteries (302) qui collecte les données de cellules de chaînes de batteries à partir d'une chaîne de batteries (304) ; dans lequel la chaîne de batteries comprend une donnée de cellule pour chaque cellule dans la chaîne de batteries ;
l'ordinateur étant agencé pour afficher les données de cellules de chaînes sous forme graphique dans une image graphique à coordonnées polaires d'une image graphique à roue et à rayons (400) comportant un rayon s'étendant à partir d'un moyeu pour chaque donnée de cellule, dans lequel chaque rayon est mis à échelle pour que sa longueur corresponde à une valeur de la donnée de cellule.

2. Système selon la revendication 1, dans lequel l'ordinateur reçoit des données de cellules de chaînes de batteries pour une pluralité de chaînes de batteries et affiche, simultanément, sur l'écran d'affichage, les données de cellules de chaînes de batteries pour chaque chaîne de batteries avec les données de cellules de chaînes de batteries pour chaque chaîne de batteries affichées sur l'écran d'affichage dans une image graphique à coordonnées polaires séparée.

3. Système selon la revendication 2, dans lequel les données de cellules de chaînes de batteries pour chaque chaîne de batteries comprennent une donnée de cellule pour chaque cellule dans la chaîne de batteries, dans lequel l'image graphique à coordonnées polaires comprend une image à roue et à rayons comportant un rayon s'étendant à partir d'un moyeu pour chaque donnée de cellule, dans lequel chaque rayon est mis à échelle pour que sa longueur corresponde à une valeur de la donnée de cellule.

4. Système de surveillance de batteries, comprenant :
une chaîne de batteries comprenant une donnée de cellule pour chaque cellule dans la chaîne de batteries ;
un écran d'affichage (308) ;
un dispositif de surveillance de batteries qui surveille et collecte des données de cellules de chaînes de batteries à partir de la chaîne de batteries ; un ordinateur qui reçoit des données de cellules de la chaîne de batteries (304) à partir du dispositif de surveillance de batteries (302) ; l'ordinateur (306) étant agencé pour afficher les données de cellules de chaînes de batteries sur l'écran d'affichage sous forme graphique dans une image graphique à coordonnées polaires d'une image graphique à roue et à rayons (400) comportant un rayon s'étendant à partir d'un moyeu pour chaque donnée de cellule dans lequel chaque rayon est mis à échelle pour que sa longueur corresponde à une valeur de la donnée de cellule.

5. Système selon la revendication 4, comprenant une pluralité de dispositifs de surveillance de batteries qui surveillent et collectent des données de cellules de chaînes de batteries à partir d'une pluralité de chaînes de batteries, l'ordinateur recevant les données de cellules de chaînes de batteries pour la pluralité de cellules de batteries à partir de la pluralité de dispositifs de surveillance de batteries et affichant, simultanément, sur l'écran d'affichage, les données de cellules de chaînes de batteries pour chaque chaîne de batteries avec les données de cellules de chaînes de batteries pour chaque chaîne de batteries affichées sur l'écran d'affichage dans une image graphique à coordonnées polaires séparée.

6. Système selon la revendication 5, dans lequel les données de cellules de chaînes de batteries pour chaque chaîne de batteries comprennent une donnée de cellule pour chaque cellule dans la chaîne de batteries, dans lequel l'image graphique à coordonnées polaires comprend une image à roue et à rayons comportant un rayon s'étendant à partir d'un moyeu pour chaque donnée de cellule, dans lequel chaque rayon est mis à échelle pour que sa longueur corresponde à une valeur de la donnée de cellule.

7. Procédé d'affichage de données de cellules de chaînes de batteries, comprenant :
la réception, avec un ordinateur (306), des données de cellules de chaînes de batteries à partir d'un dispositif de surveillance de batteries (302) qui collecte les données de cellules de chaînes de batteries à partir de la chaîne de batteries (304), dans lequel la chaîne de batteries comprend une donnée de cellule pour chaque cellule dans la chaîne de batteries ; et
le formatage, avec l'ordinateur, des données de cellules de chaînes de batteries en une image graphique à coordonnées polaires d'une image graphique à roue et à rayons (400) comportant un rayon s'étendant à partir d'un moyeu pour chaque donnée de cellule, dans lequel chaque rayon est mis à échelle pour que sa longueur corresponde à une valeur de la donnée de cellule et l'affichage, avec l'ordinateur, de l'image graphique à roue et à rayons sur l'écran d'affichage.

8. Procédé selon la revendication 7, comprenant la réception, avec l'ordinateur, de données de cellules de chaînes de batteries pour une pluralité de chaînes de batteries et, avec l'ordinateur, l'affichage, simultanément, sur l'écran d'affichage, des données de cellules de chaînes de batteries pour chaque chaîne de batteries avec les données de cellules de chaînes de batteries pour chaque chaîne de batteries affichées sur l'écran d'affichage dans une image graphique à roue et à rayons séparée, dans lequel l'image graphique à roue et à rayons pour chaque chaîne de batteries comporte un rayon s'étendant à partir d'un moyeu pour chaque donnée de cellule de la chaîne de batteries qui est mis à échelle pour que sa longueur corresponde à la valeur de la donnée de cellule.

9. Procédé selon la revendication 8, dans lequel chaque rayon est un quelconque parmi un trait ou un segment en forme de secteur.
